# EUROPÄISCHE PATENTSCHRIFT

(11) **EP 0 427 053 B1**
(45) Veröffentlichungstag und Bekanntmachung des Hinweises auf die Patenterteilung: **26.01.1994**
(21) Anmeldenummer: 90120513.8
(22) Anmeldetag: 26.10.1990
(51) Int. Cl.: B05B 13/02, B65G 47/252

(54) **Vorrichtung und Verfahren zum Beschichten von Leiterplatten**
Device and method for coating printed circuit plates
Dispositif et procédé de revêtement des cartes de circuits imprimés

(30) Priorität: 07.11.1989 DE 3937071
(43) Veröffentlichungstag der Anmeldung: 15.05.1991
(73) Patentinhaber: BÖLLHOFF VERFAHRENSTECHNIK GMBH & CO. KG, D-33647 Bielefeld (DE)
(72) Erfinder: Heine, Werner, W-7057 Winnenden 6 (DE)
(74) Vertreter: Knoblauch, Ulrich, Dr.-Ing.

(56) Entgegenhaltungen:
- DE-A- 3 631 270
- FR-A- 2 206 684
- GB-A- 783 182
- IBM TECHNICAL DISCLOSURE BULLETIN Bd. 17, Nr. 4, 1. September 1974, Seite 1065;COCHRAN, GASPARRI, RANCE: 'Inverter for flat parts being indexed on a belt. '

## Beschreibung

Die Erfindung bezieht sich auf eine Vorrichtung und ein Verfahren zum Beschichten von nach dem Oberbegriff des Ansprüchs 1 bw.13.

Eine solche Vorrichtung ist aus DE-A-36 31 270 bekannt. Die Beschichtung mit Fotolack oder Lötstoplacken erfolgt elektrostatisch unter Verwendung eines Rotationszerstäubers bei kontinuierlichem Durchlauf. Im Anschluß an die Beschichtungszone ist eine Trocknungszone vorgesehen.

Eine solche Vorrichtung erlaubt die vollautomatische Handhabung der Substrate, insbesondere ein automatisches Aufgeben auf den Förderer. Es ergeben sich verhältnismäßig hohe Durchsatzzahlen. Die Substrate sind aber nur einseitig beschichtet. Eine zweiseitige Beschichtung wäre nur mit Hilfe eines zweiten Durchlaufs möglich, was wegen der Trocknung der ersten Schicht keine Schwierigkeiten beim Abstützen macht, aber die doppelte Zeit erfordert und wegen der doppelten Trocknung der ersten Schicht zu deren Übertrocknung führen kann.

Ein kontinuierliches Verfahren zur zweiseitigen Beschichtung von Substraten ist aus DE-A-37 35 798 bekannt. Hier werden die Substrate vertikal hängend zunächst von der einen und dann von der anderen Seite her beschichtet, worauf beide Seiten gemeinsam getrocknet werden. Wenn beide Sprühvorrichtungen auf der gleichen Seite der Förderbahn angeordnet sein sollen, muß auf dem Förderweg zwischen den Sprühvorrichtungen eine Drehvorrichtung vorgesehen werden, welche die Substrate um 180° um eine vertikale Achse dreht. Das Anbringen der Substrate am Förderer und das Abnehmen vom Förderer muß von einer Bedienungsperson vorgenommen werden. Zwischen den Substraten verbleiben Zwischenräume, durch die ein Teil des von den Sprühvorrichtungen abgegebenen Materials hindurchtritt. Außerdem ist die Beschichtung ungleichmäßig, weil wegen der Schwerkraft die dicken Lacktröpfchen durch ihr Gewicht nach unten abgelenkt werden und weil das Beschichtungsmaterial, wenn es keine ausreichende Viskosität hat, nach unten läuft. Ferner verschmutzt der Förderer stark; dies gilt insbesondere bei einer elektrostatischen Beschichtung.

In dem IBM Technical Disclosure Bulletin, Vol. 17, Nr. 4, September 1974, Seite 1065 ist eine Wendevorrichtung für flache Halbleiterteile offenbart, die in Taschen eines Bandes antransportiert und nach einem Umwenden um 180° in Taschen des Bandes wieder abtransportiert werden. Die Wendevorrichtung besteht aus zwei Scheiben mit außermittig beginnenden Radialnuten. In diese werden die Halbleiterteile mittels des Bandes eingeschoben und nach dem Umwenden mittels des Bandes aus diesen wieder entfernt.

Der Erfindung liegt die Aufgabe zugrunde, eine Beschichtungsvorrichtung der eingangs beschriebenen Art anzugeben, mit der plattenförmige Substrate in horizontalem kontinuierlichen Durchlauf beidseitig beschichtet und beide Schichten dann gemeinsam getrocknet werden können.

Diese Aufgabe wird erfindungsgemäß durch die Kennzeichnenden Merkmale des Anspruchs 1 gelöst,

Die über eine Wendevorrichtung verbundenen beiden Beschichtungsstationen erlauben die beidseitige Beschichtung der Leiterplatten. Beide Schichten haben wegen der horizontalen Lage eine große Gleichmäßigkeit. Die Anordnung und Auslegung der Stützelemente des zweiten Förderers berücksichtigt, daß die Unterseite der Leiterplatten eine Schicht aus nassem Beschichtungsmaterial trägt. Wenn die Stützelemente an funktionsfreien Bereichen, bei Leiterplatten also an leiterbahnfreien Bereichen, angreifen, ist eine Beschädigung der nassen Beschichtung für den späteren Verwendungszweck unschädlich. Wegen der guten Ausnutzung der Oberfläche solcher Leiterplatten sind die funktionsfreien Bereiche in der Regel aber sehr klein oder schmal. Dem muß die Gestaltung der Stützelemente Rechnung tragen. Daher ist es möglich, die Leiterplatte ohne jegliche Zwischentrocknung auf der bereits beschichteten Seite abzustützen, um die zweite Beschichtung vorzunehmen. Beide Schichten werden auch in gleichem Maße getrocknet. Es besteht weder die Gefahr der Übertrocknung auf der einen Seite noch die Gefahr einer ungenügenden Trocknung auf der anderen Seite. Die Vorrichtung hat eine hohe Durchlaufkapazität. Sie kann automatisch beladen und entladen, insgesamt also vollautomatisiert werden.

Die Stützelemente greifen an den Randbereichen der Leiterplatten an, und zwar an den beiden in Förderrichtung verlaufenden Randbereichen der Leiterplatten an. Dies erlaubt eine sehr gute Ausrichtung der Stützelemente mit den funktionsfreiten Bereichen.

Da die Stützelemente eine punkt- oder linienförmige Stützfläche aufweisen, läßt sich eine Abstützung auch auf äußerst schmalen funktionsfreien Bereichen, beispielsweise mit einer Breite von nur 2 mm, vornehmen.

Bei einer bevorzugten Ausführungsform sind die Stützelemente durch sich in Förderrichtung erstreckende Schneiden gebildet. Diese Schneiden führen zu einer ausreichenden Abstützung bei äußerst geringer Breite.

Des weiteren empfiehlt es sich, daß in der ersten Beschichtungsstation Abdeckungen zum Freihalten der Randbereiche, an denen in der zweiten Beschichtungsstation die Stützelemente angreifen, vorgesehen sind. Die Abdeckungen sorgen daher dafür, daß funktionsfreie Bereiche freigehalten, die gesamte übrige Fläche aber beschichtet ist. Hiermit wird einer Verschmutzung der Stützelemente entgegengewirkt.

Um die Stützelemente sauber zu halten, kann auch eine Reinigungsvorrichtung für die Stützelemente am Rücklauftrum des zweiten Förderers vorgesehen sein.

Günstig ist es auch, daß die Wendevorrichtung rechteckförmige Leiterplatten mit Hilfe eines Ausstossers Stoß an Stoß auf dem zweiten Förderer ablegt. Die Leiterplatten bilden daher eine durchgehende Fläche. Es gibt keine Verluste durch Overspray zwischen aufeinanderfolgenden Leiterplatten. Eine Verschmutzung der Stützelemente durch Beschichtungsmaterial aus der zweiten Sprühvorrichtung ist unterbunden.

Der Wendevorrichtung kann mit Vorteil ein Zwischenförderer vorgeschaltet sein, der eine höhere Geschwindigkeit besitzt als der erste und zweite Förderer. Dies führt zu einer Separation der Leiterplatten beim Übergang vom ersten Förderer auf den Zwischenförderer, was das Wendemanöver erleichtert. Wenn der erste und zweite Förderer die gleiche Geschwindigkeit haben, nehmen die Leiterplatten auf dem zweiten Förderer in gewendeter Form die gleiche Position ein wie auf dem ersten Förderer.

Mit besonderem Vorteil weist der zweite Förderer zwei Stützelementreihen auf, deren Abstand voneinander einstellbar ist. Auf diese Weise kann eine Anpassung an Leiterplatten unterschiedlicher Breite sowie an die Lage der funktionsfreien Bereiche vorgenommen werden.

Unterhalb der Bewegungsbahn der Leiterplatten sollte eine Auffangvorrichtung vorgesehen sein. Hierdurch wird der Overspray aufgefangen und kann gegebenenfalls zur Wiederverwendung abgeführt werden.

Mit Vorteil hat die Auffangvorrichtung eine größere Breite als die Leiterplatten und besitzt parallele Schlitze für den Durchtritt der Stützelemente. Die Schlitze sind der Breite der Stützelemente angepaßt, können also bei Verwendung von Schneiden sehr schmal gehalten werden.

Insbesondere besitzt die Auffangvorrichtung einen feststehenden Mittelabschnitt und mindestens einen einen Schlitz aufweisenden Seitenabschnitt, der zusammen mit der zugehörigen Stützelementreihe verstellbar ist. Auf diese Weise hat die Auffangvorrichtung immer eine der Abstandseinstellung der Stützelementreihen angepaßte Form.

Günstig ist es auch, daß eine elektrostatische Beschichtungsvorrichtung vorgesehen ist und die Schneiden elektrisch leitend sind und an Massepotential liegen. Da die Schneiden weitgehend sauber gehalten und direkt mit der Unterseite der Leiterplatte in Berührung gebracht werden können, ergibt sich ein entsprechend guter Masseanschluß. Dieser kann in üblicher Weise noch durch einen Galvanorand an den Leiterplatten verbessert werden.

Bei einem bevorzugten Ausführungsbeispiel ist ferner dafür gesorgt, daß die Wendevorrichtung mit Klemmelementen versehen ist, die - soweit sie an der bereits beschichteten Seite der Leiterplatten wirksam sind - an funktionsfreien Bereichen der Leiterplatten angreifen und/oder Eindruckstellen im nassen Beschichtungsmaterial erzeugen, die nach Trennung von Leiterplatte und Klemmelementen durch seitlich zufließendes Beschichtungsmaterial weitgehend wieder auffüllbar sind. Auch die Klemmelemente beeinträchtigen daher nicht die bereits aufgebrachte Schicht aus nassem Beschichtungsmaterial.

Ein erfindüngsgemäßes Verfahren ergibt sich aus Anspruch 13.

Die Erfindung wird nachstehend anhand in der Zeichnung dargestellter bevorzugter Ausführungsbeispiele näher erläutert. Es zeigen:
- Fig. 1: eine schematische Darstellung einer Vorrichtung gemäß der Erfindung,
- Fig. 2: in vergrößerter Darstellung eine Seitenansicht des zweiten Förderers,
- Fig. 3: eine Draufsicht auf rechteckige Leiterplatten in der zweiten Beschichtungszone,
- Fig. 4: einen Querschnitt durch den zweiten Förderer,
- Fig. 5: einen Teilquerschnitt durch den ersten Förderer,
- Fig. 6: eine Ausführungsform der Stütz- oder Klemmelemente,
- Fig. 7: eine andere Ausführungsform der Stütz- oder Klemmelemente,
- Fig. 8: eine dritte Form der Stütz- oder Klemmelemente,
- Fig. 9: eine schematische Seitenansicht der Wendevorrichtung und
- Fig. 10: die gleiche Vorrichtung mit Ausstoßer.

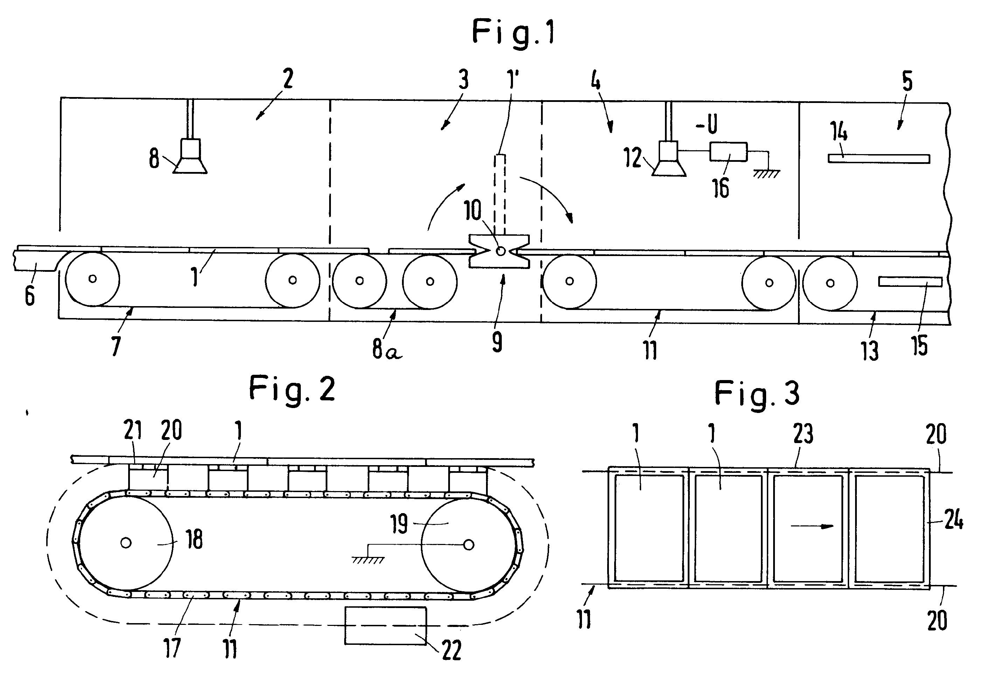

In der Vorrichtung der Fig. 1 durchlaufen plattenförmige Leiterplatten 1 eine erste Beschichtungsstation 2, eine Wendezone 3 und eine zweite Beschichtungszone 4, ehe sie in eine Trockenzone 5 gelangen. Die Leiterplatten 1 werden vollautomatisch auf einem Aufgabetisch 6 in die Vorrichtung eingeführt und auf einem ersten Förderer 7 abgelegt. Auf ihm laufen sie unter einer ersten Sprühvorrichtung 8 hindurch. In der Wendezone 3 werden die Leiterplatten 1 an einen mit höherer Geschwindigkeit als dem ersten Förderer 7 laufenden Zwischenförderer 8a übergeben, so daß ein Zwischenraum zwischen ihnen entsteht. Es folgt eine Wendevorrichtung 9, welche die zunächst an der Oberseite beschichteten Leiterplatten 1 ergreift und um 180° über die gestrichelte Position 1' um die Achse 10 schwenkt, so daß nunmehr die beschichtete Seite nach unten zu liegen kommt. Die Leiterplatten 1 werden in der zweiten Beschichtungszone 4 vom zweiten Förderer 11 unter einer zweiten Sprühvorrichtung 12 hindurch bewegt, wo sie nunmehr von oben her beschichtet werden. Schließlich gelangen die beidseitig beschichteten Leiterplatten 1 auf einen Trockenförderer 13, der sie durch die Trockenzone 5 hindurchtransportiert, wo sie von Infrarot-Strahlern 14 und 15 und/oder Umluft getrocknet werden.

Die Sprühvorrichtungen 8 und 12 können den gleichen Aufbau haben. Sie können aber auch nach unterschiedlichen Prinzipien arbeiten. In Fig. 1 sollen die Sprühvorrichtungen 8 und 12 durch einen Hochrotationszerstäuber mit elektrostatischer Aufladung gebildet sein. Hierbei ist ein Hochspannungsgenerator 16 schematisch veranschaulicht, der mit einem Pol an Masse liegt und dessen anderer Pol, an dem eine negative Gleichstrom-Hochspannung ansteht, an den Hochrotationszerstäuber angeschlossen ist. In Abhängigkeit von der Beschichtungsaufgabe können die passenden Sprühvorrichtungen nach Art eines Baukastensystems eingesetzt werden. Das Gegenpotential wird durch die Leiterplatten gebildet, die über die zugehörigen Förderer mit Masse verbunden sind.

In Fig. 2 ist der zweite Förderer 11 veranschaulicht. Er besitzt zwei Ketten 17, die um entsprechende Kettenräder 18 und 19, von denen eines angetrieben ist, gelegt sind. Die Ketten tragen Stützelemente 20 mit Schneiden 21, auf denen die Leiterplatten 1 abgestützt sind. Die Schneiden 21 werden in einer Reinigungsvorrichtung 22, die dem Rücklauftrum zugeordnet ist, gesäubert. Kettenräder, Ketten und Schneiden bestehen aus elektrisch leitendem Material und sind, wie es beim Kettenrad 19 gezeigt ist, an Masse gelegt.

Gemäß Fig. 3 sind die Leiterplatten 1 rechteckig und liegen auf dem zweiten Förderer 11 Stoß an Stoß auf. Die Stützelemente 20 stützen die Leiterplatten 1 mit ihren Schneiden 21 an sehr schmalen Randbereichen 23 ab, wo sich Basismaterial oder ein ringsum laufender elektrisch leitender Rahmen 24 aus Metall (Galvanorand) befinden. Über diesen leitenden Rahmen sind die Leiterplatten 1 mit der dem Kettenrad 19 zugeordneten Masse verbunden.

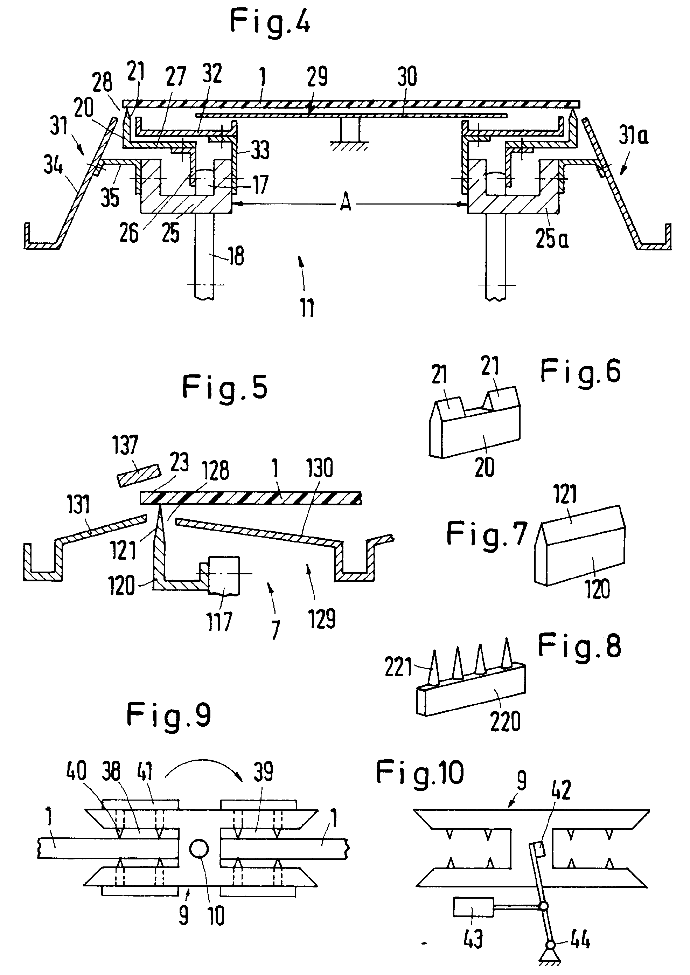

Wie Fig. 4 zeigt, sind die Ketten 17 in einem U-Profil 25 geführt. Sie tragen über Winkelprofile 26 die ebenfalls an einem Winkelprofil 27 ausgebildeten Schneiden 21. Die Schneiden ragen durch einen Schlitz 28 nach außen, der in einer Auffangvorrichtung 29 vorgesehen ist. Diese weist einen feststehenden Mittelabschnitt 30 in Form einer Blechplatte und zwei Seitenabschnitte 31 und 31a auf, die an den U-Profilen 25 und 25a befestigt sind. Der Seitenabschnitt 31 weist eine innere Rinne 32 auf, der mittels eines Winkels 33 am U-Profil 25 angebracht ist, sowie ein äußeres, unten rinnenförmig ausgebildetes Blech 34, das über ein Winkelprofil 35 mit dem U-Profil 25 verbunden ist. Der gleiche Aufbau ergibt sich auch auf der rechten Seite der Fig. 4. Zu beiden Seiten der Leiterplatten 1 auftreffendes Beschichtungsmaterial wird durch die Bleche 34 aufgefangen und zur Wiederverwendung abgeführt. Falls zwischen aufeinanderfolgenden Leiterplatten 1 eine Lücke verbleibt, trifft das Beschichtungsmaterial auf die feststehende Platte 30 und die beiden Rinnen 32. Daher ist die gesamte Einrichtung unterhalb dieser Auffangvorrichtung 29 vor Verschmutzung gesichert.

Ein Pfeil A soll andeuten, daß der Abstand zwischen den U-Profilen 25 und 25a eingestellt werden kann, was zu einer Änderung des Spurabstandes der Kettenräder 18 und der Stützelemente 20 führt, wie dies zur Anpassung an andere Abmessungen der Leiterplatten bzw. zur genauen Anpassung an die funktionsfreien Randbereiche erwünscht ist.

In Fig. 5 ist ein Teilquerschnitt durch den ersten Förderer 7 veranschaulicht. Hier sind Stützelemente 120 mit Schneiden 121 an einer Kette 117 in ähnlicher Weise angebracht, wie dies in Fig. 4 für den zweiten Förderer 11 veranschaulicht ist. Eine Auffangvorrichtung 129 weist einen Mittelabschnitt 130 mit Ablaufrinne und Seitenabschnitte 131 ebenfalls mit Ablaufrinne auf.

Zwischen beiden gibt es einen Schlitz 128. Eine leistenförmige Abdeckung 137 deckt den schmalen Randbereich 23 der Leiterplatte 1 ab, so daß dort keine Beschichtung stattfindet.

Fig. 6 zeigt, daß das Stützelement 20 jeweils mit zwei Schneiden 21 versehen ist. Gemäß Fig. 7 kann das Stützelement 120 auch mit einer durchgehenden Schneide 121 ausgestattet sein. Fig. 8 zeigt eine Alternative, wo ein Stützelement 220 mit Stütznadeln 221 versehen ist. Auf diese Weise ergeben sich linienförmige bzw. punktförmige Abstützungen.

Die Wendevorrichtung 9 weist gemäß Fig. 9 zwei Aufnahmeöffnungen 38 und 39 auf, die um 180° gegeneinander versetzt sind. In jeder Aufnahmeöffnung sind Klemmelemente 40 vorgesehen, die mittels einer willkürlich zu betätigenden Druckvorrichtung 41 gegen die Leiterplatte 1 gedrückt werden kann. Im Ausführungsbeispiel sind spitzenförmige Klemmelemente an Kolben angebracht die durch einen druckbelasteten Zylinder gegen die Leiterplatte gepreßt werden. Es kommen aber auch druckmittelbelastete Membranen, Federanordnungen u. dgl. in Betracht. Die Klemmelemente 40 wirken an den gleichen Randbereichen 23, an denen auch die Stützelemente angreifen. Es kommen nicht nur spitzenförmige, sondern auch schneidenförmige Klemmelemente in Betracht, wofür die Fig. 6 bis 8 Beispiele darstellen.

Gemäß Fig. 10 ist der Wendevorrichtung 9 ein Ausstoßer 42 zugeordnet, der mittels eines Stellmotors 43 um einen Drehpunkt 44 Schwenkbar ist. Mit dem Ausstoßer 42 wird die gewendete Leiterplatte 1 auf den zweiten Förderer 11 geschoben, bis es Stoß an Stoß an der vorangehenden Leiterplatte anliegt.

Bei einem Ausführungsbeispiel hatten die Schneiden 21 eine Länge von etwa 5 mm und waren in Abständen zwischen 50 und 100 mm am Förderer angeordnet. Die Schneiden 21 ragten 2 bis 5 mm über die Bleche der Auffangvorrichtung 29 hinaus.

Die beschriebene Vorrichtung eignet sich insbesondere zum beidseitigen Beschichten von Leiterplatten mit Fotolack (Fotoresist) und Lötstoplack.

Anstelle der veranschaulichten Hochrotationszerstäuber können auch Sprühvorrichtungen in der Form von mit oder ohne Luftunterstützung arbeitenden Drucksprühvorrichtungen (Airless-Verfahren) verwendet werden.

## Patentansprüche

1. Vorrichtung zum Beschichten von Leiterplatten (1) mit einer Beschichtungsstation (2), die eine nach unten wirkende Sprühvorrichtung (8) aufweist, unter der ein kontinuierlich arbeitender Förderer (7) zum Transport von etwa horizontal liegenden Leiterplatten verläuft, gekennzeichnet durch eine zweite Beschichtungsstation (4), die eine zweite nach unten wirkende Sprühvorrichtung (12) aufweist, unter der ein zweiter kontinuierlich arbeitender Förderer (11) zum Transport von etwa horizontal liegenden Leiterplatten (1) verläuft, durch eine zwischen den beiden Beschichtungsstationen (2, 4) angeordnete Wendevorrichtung (9), die die einseitig beschichteten Leiterplatten (1) mit der Oberseite nach unten auf den zweiten Förderer (11) legt, und durch mit Abstand längs des zweiten Förderers (11) angeordnete Stützelemente (20; 120; 220) mit punkt- oder linienförmiger Stützfläche, die an der Unterseite der Leiterplatte (1) an in Förderrichtung verlaufenden, sehr schmalen Randbereichen (23) angreifen, an denen sich das Basismaterial der Leiterplatte oder ein elektrisch leitender Rahmen (24) aus Metall befinden.

2. Vorrichtung nach Anspruch 1, dadurch gekennzeichnet, daß die Stützelemente (20; 120) durch sich in Förderrichtung erstreckende Schneiden (21; 121) gebildet sind.

3. Vorrichtung nach Anspruch 1 oder 2, dadurch gekennzeichnet, daß in der ersten Beschichtungsstation (2) Abdeckungen (137) zum Freihalten der Randbereiche, an denen in der zweiten Beschichtungsstation (4) die Stützelemente (20) angreifen, vorgesehen sind.

4. Vorrichtung nach einem der Ansprüche 1 bis 3, dadurch gekennzeichnet, daB eine Reinigungsvorrichtung (22) für die Stützelemente (20) am Rücklauftrum des zweiten Förderers (11) vorgesehen ist.

5. Vorrichtung nach einem der Ansprüche 1 bis 4, dadurch gekennzeichnet, daß die Wendevorrichtung (9) rechteckförmige Leiterplatten (1) mit Hilfe eines Ausstossers (42) Stoß an Stoß auf dem zweiten Förderer (11) ablegt.

6. Vorrichtung nach einem der Ansprüche 1 bis 5, dadurch gekennzeichnet, daß der Wendevorrichtung (g) ein Zwischenförderer (8) vorgeschaltet ist, der eine höhere Geschwindigkeit besitzt als der erste und zweite Förderer (7, 11).

7. Vorrichtung nach einem der Ansprüche 1 bis 6, dadurch gekennzeichnet, daß der zweite Förderer (11) Stützelementreihen aufweist, deren Abstand voneinander einstellbar ist.

8. Vorrichtung nach einem der Ansprüche 1 bis 7, dadurch gekennzeichnet, daß unterhalb der Bewegungsbahn der Leiterplatten (1) eine Auffangvorrichtung (29; 129) vorgesehen ist.

9. Vorrichtung nach Anspruch 8, dadurch gekennzeichnet, daß die Auffangvorrichtung (29; 129) eine größere Breite als die Leiterplatten (1) hat und parallele Schlitze (28; 128) für den Durchtritt der Stützelemente (20; 120) besitzt.

10. Vorrichtung nach Anspruch 8 oder 9, dadurch gekennzeichnet, daß die Auffangvorrichtung (29) einen feststehenden Mittelabschnitt (30) und mindestens einen einen Schlitz (28) aufweisenden Seitenabschnitt (31) besitzt, der zusammen mit der zugehörigen Stützelementreihe verstellbar ist.

11. Vorrichtung nach einem der Ansprüche 1 bis 10, dadurch gekennzeichnet, daß eine elektrostatische Beschichtungsvorrichtung vorgesehen ist und die Schneiden (21) elektrisch leitend sind und an Massepotential liegen.

12. Vorrichtung nach einem der Ansprüche 1 bis 11, dadurch gekennzeichnet, daß die Wendevorrichtung (9) mit Klemmelementen (40) versehen ist, die - soweit sie an der bereits beschichteten Seite der Leiterplatten (1) wirksam sind - an den sehr schmalen Randbereichen (23) der Leiterplatten angreifen.

13. Verfahren zum Beschichten von Leiterplatten unter Verwendung einer Vorrichtung nach einem der vorhergehenden Ansprüche, bei dem die Leiterplatten horizontal durch eine erste Beschichtungszone transportiert, dann gewendet und mit der nassen Seite nach unten durch eine zweite Beschichtungszone transportiert sowie anschließend beide Schichten gemeinsam getrocknet werden.

## Claims

1. Device for coating printed circuit boards (1), comprising a coating station (2) having a downwardly operating sprayer (8) below which a continuously operating conveyor (7) for the transportation of substantially horizontal printed circuit boards extends, characterised by a second coating station (4) having a second downwardly operating sprayer (12) below which a second continuously operating conveyor (11) for the transportation of substantially horizontal printed circuit boards (1) extends, a turning device (9) which is arranged between the two coating stations (2, 4) and deposits the printed circuit boards (1) coated on one side on the second conveyor (11) with the upper surface facing downwards, and supporting elements (20; 120; 220) arranged at intervals along the second conveyor (11) with point or line supporting faces which extend in the feed direction along the underside of the printed circuit board (1) and contact very narrow edge regions (23) at which the base material of the printed circuit board or an electrically conductive frame (24) of metal is situated.

2. Device according to claim 1, characterised in that the supporting elements (20; 120) are formed by cutting edges (21; 121) extending in the feed direction.

3. Device according to claim 1 or claim 2, characterised in that covers (137) for keeping clear the edge regions contacted by the supporting elements (20) in the second coating station (4) are provided in the first coating station (2).

4. Device according to one of claims 1 to 3, characterised in that a cleaning device (22) for the supporting elements (20) is provided on the slack side of the second conveyor (11).

5. Device according to one of claims 1 to 4, characterised in that the turning device (9) deposits rectangular printed circuit boards (1) in an abutting manner on the second conveyor (11) with the aid of an ejector (42).

6. Device according to one of claims 1 to 5, characterised in that an intermediate conveyor (8) having a higher speed than the first and second conveyors (7, 11) is arranged in front of the turning device (9).

7. Device according to one of claims 1 to 6, characterised in that the second conveyor (11) has rows of supporting elements arranged at adjustable intervals.

8. Device according to one of claims 1 to 7, characterised in that a collecting device (29; 129) is provided below the path of motion of the printed circuit boards (1).

9. Device according to claim 8, characterised in that the collecting device (29; 129) has a larger width than the printed circuit boards (1) and has parallel slots (28; 128) for the passage of the supporting elements (20; 120).

10. Device according to claim 8 or claim 9, characterised in that the collecting device (29) has a fixed centre portion (30) and at least one side portion (31) having a slot (28) which can be adjusted together with the associated row of supporting elements.

11. Device according to one of claims 1 to 10, characterised in that an electrostatic coating device is provided and the cutting edges (21) are electrically conductive and are earthed.

12. Device according to one of claims 1 to 11, characterised in that the turning device (9) is provided with clamping elements (40) which, provided that they act upon the already coated side of the printed circuit boards (1), contact the very narrow edge regions (23) of the printed circuit boards.

13. Method for coating printed circuit boards using a device according to one of the preceding claims, in which the printed circuit boards are transported horizontally through a first coating zone and are then turned and are transported through a second coating zone with the wet side facing downwards and then both layers are dried together.

## Revendications

1. Dispositif pour le revêtement de plaquettes ou cartes de circuits imprimés (1) avec un poste de revêtement (2) qui comporte un dispositif de pulvérisation (8) agissant par le dessous, dispositif sous lequel s'étend un convoyeur (7) fonctionnant en continu pour l'acheminement de plaquet- tes de circuits imprimés disposées sensiblement horizontalement, caractérisé par un deuxième poste de revêtement (4) qui comporte un deuxième dispositif de pulvérisation (12) agissant par le dessous, dispositif sous lequel s'étend un deuxième convoyeur fonctionnant en continu (11) pour l'acheminement de plaquettes de circuits imprimés disposées sensiblement de façon horizontale par un dispositif de retournement (9) disposé entre les deux postes de revêtement (2, 4), dispositif de retournement qui dépose les plaquettes de circuits imprimés revêtues sur un côté (1) avec le côté dirigé vers le bas sur le deuxième convoyeur (11), et par des éléments d'appui (20 ; 120 ; 220) disposés à une certaine distance le long du deuxième convoyeur (11), élément d'appui qui attaque sur le côté inférieur des plaquettes de circuits imprimés (1) se déplaçant dans le sens de marche du convoyeur, de très étroites zones marginales (23) sur lesquelles se trouvent le matériau de base des plaquettes de circuits imprimés ou un cadre (24) conducteur électriquement en métal.

2. Dispositif selon la revendication 1, caractérisé en ce que les éléments d'appui (20 ; 120) sont formés par des découpes (21 ; 121) s'étendant dans le sens de marche du convoyeur.

3. Dispositif selon la revendication 1 ou 2, caractérisé en ce que dans le premier poste de revêtement (2) sont prévus des caches (137) pour préserver les zones marginales sur lesquelles attaquent les éléments d'appui (20) dans le deuxième poste de revêtement (4).

4. Dispositif selon l'une des revendications 1 à 3, caractérisé en ce qu'un dispositif de nettoyage (22) est prévu pour les éléments d'appui (20) sur le brin de retour du deuxième convoyeur (11).

5. Dispositif selon l'une des revendications 1 à 4, caractérisé en ce que le dispositif de retournement (9) dépose des plaquettes de circuits imprimés rectangulaires (1) à l'aide d'un élément pousseur éjecteur (42) bord à bord sur le deuxième convoyeur (11).

6. Dispositif selon l'une des revendications 1 à 5, caractérisé en ce qu'en amont du dispositif de retournement (9) est implanté un convoyeur intermédiaire (8) qui fonctionne à une vitesse supérieure au premier et au deuxième convoyeur (7, 11).

7. Dispositif selon l'une des revendications 1 à 6, caractérisé en ce que le deuxième convoyeur (11) comporte des séries d'éléments d'appui avec un espacement réglable entre elles.

8. Dispositif selon l'une des revendications 1 à 7, caractérisé en ce qu'en dessous de la voie de déplacement des plaques de circuits imprimés (1), il est prévu un dispositif de réception (29 ; 129).

9. Dispositif selon la revendication 8, caractérisé en ce que le dispositif de réception (29 ; 129) présente une plus grande largeur que les plaques de circuits imprimés (1) et comporte des fentes parallèles (28 ; 128) pour le passage des éléments d'appui (20 ; 120).

10. Dispositif selon la revendication 8 ou 9, caractérisé en ce que le dispositif de réception (29) possède une section médiane fixe (30) et au moins une section latérale (31) comportant une fente (28) qui peut être réglée conjointement avec la série d'éléments d'appui affectée.

11. Dispositif selon l'une des revendications 1 à 10, caractérisé en ce qu'il est prévu un dispositif de revêtement électrostatique et les coupes (21) sont électriquement conductrices et reposent sur le potentiel de masse.

12. Dispositif selon l'une des revendications 1 à 11, caractérisé en ce que le dispositif de retournement (9) est muni d'éléments de bridage (40) qui - dans la mesure où ils sont efficaces sur le côté déjà revêtu des plaquettes de circuits imprimés (1) - s'engagent sur les zones marginales très étroites (23) des plaquettes de circuits imprimés.

13. Dispositif pour le revêtement de plaquettes de circuits imprimés faisant appel à un dispositif selon l'une des revendications précédentes, dans lequel les plaquettes de circuits imprimés sont acheminées horizontalement à travers une première zone de revêtement puis retournées et acheminées avec le côté humide vers le bas à travers une deuxième zone de revêtement puis consécutivement les deux couches sont séchées conjointement.
